# EUROPÄISCHE PATENTSCHRIFT

(11) **EP 3 060 790 B1**
(45) Veröffentlichungstag und Bekanntmachung des Hinweises auf die Patenterteilung: **26.05.2021**
(21) Anmeldenummer: 14783873.4
(22) Anmeldetag: 14.10.2014
(51) Int. Cl.: F02M 51/06, F02M 51/00, H01L 41/053

(54) **INJEKTOR**
INJECTOR
INJECTEUR

(30) Priorität: 23.10.2013 DE 102013221515
(43) Veröffentlichungstag der Anmeldung: 31.08.2016
(73) Patentinhaber: Vitesco Technologies GmbH, 30165 Hannover (DE)
(72) Erfinder: SANFTLEBEN, Emanuel, 93102 Pfatter (DE); PLÖTZ, Martin, 93053 Regensburg (DE); SIMMET, Martin, 93077 Bad Abbach (DE); KERNBACH, Steffen, 93051 Regensburg (DE)
(86) Internationale Anmeldenummer: PCT/EP2014/071967
(87) Internationale Veröffentlichungsnummer: WO 2015/058998

(56) Entgegenhaltungen:
- EP-A1- 1 630 408
- EP-A1- 2 444 650
- EP-A2- 1 712 774
- DE-A1-102007 055 896
- DE-A1-102009 046 311
- DE-A1-102009 046 314
- DE-A1-102011 081 343

## Beschreibung

Die vorliegende Erfindung betrifft einen Injektor eines Einspritzsystems einer Brennkraftmaschine mit einem Injektorgehäuse, einer piezoaktuatorischen Steuereinheit, einem Verbindungsstecker am Kopf des Injektorgehäuses und einer elektrischen Verbindung zwischen der Steuereinheit und dem Verbindungsstecker innerhalb des Injektorgehäuses.

Ein derartiger Injektor ist bekannt. Die piezoaktuatorische Steuereinheit befindet sich hierbei nahe an der Düseneinheit. Zur elektrischen Kontaktierung dieser Steuereinheit kommt ein Verbindungsstecker zum Einsatz, der am Kopf des zugehörigen Injektorgehäuses angeordnet ist. Zwischen der piezoaktuatorischen Steuereinheit und dem Verbindungsstecker muss daher eine elektrische Verbindung vorgesehen ein, um die Steuereinheit mit elektrischer Energie zu versorgen. Diese elektrische Verbindung muss gegenüber äußeren Vibrationen der Brennkraftmaschine und auch gegenüber inneren Vibrationen der Steuereinheit geschützt sein.

Es ist bekannt, diese elektrische Verbindung mit Hilfe von isolierten Drähten herzustellen, wobei die piezoseitige Schweißstelle zusätzlich mit Silikon vergossen wurde. Eine solche elektrische Verbindung ist nur relativ aufwändig herzustellen und stellt letztendlich eine in Bezug auf Beschädigungen relativ anfällige Konstruktionen dar. Der Prozess ist für die Serie nicht umsetzbar.

Die DE 10 2009 046 314 A1 zeigt einen piezoelektrischen Aktor mit einem Aktorkörper, einem Übergangsstück, einem Buchsenträger und einem Steckerkörper. Es ist eine elektrische Verbindungsleitung vorgesehen, die durch das Übergangsstück geführt ist. Dabei ist eine elektrische Zuleitung vorgesehen, die durch den Steckerkörper geführt ist. Der Buchsenträger nimmt eine Buchse auf. Diese Buchse ist an einer ersten Seite mittelbar mit der Verbindungsleitung und an einer zweiten Seite mittelbar mit der Zuleitung elektrisch verbunden. Die Verbindung der Zuleitung mit der Buchse erfolgt über eine Steckerverbindung.

Die EP 1 630 408 A1 zeigt einen Kraftstoffinjektor für eine Brennkraftmaschine mit einem Kraftstoffeinspritzventil, einem in einem mittleren Bereich des Injektorgehäuses angeordneten Piezoaktor zur Betätigung des Kraftstoffeinspritzventils und eine an einem zweiten Ende des Injektorgehäuses angeordnete Kontaktbaugruppe zum elektrischen Anschluss des Kraftstoffinjektors, die zur elektrischen Kontaktierung des Piezoaktors über eine axial zwischen der Kontaktbaugruppe und dem Piezoaktor sich erstreckende Leitungsanordnung mit Kontakten des Piezoaktors verbunden ist. Die Leitungsanordnung ist von einem axial zwischen der Kontaktbaugruppe und dem Piezoaktor eingefügten Verbindungsteil ausgebildet, an dessen dem Piezoaktor zugewandten Ende Federkontakte angeordnet sind, die an einem Kontakt des Piezoaktors anliegen.

Der vorliegenden Erfindung liegt die Aufgabe zugrunde, einen Injektor der eingangs wiedergegebenen Art zur Verfügung zu stellen, der sich durch eine besonders sichere und robuste Kontaktierung zwischen der piezoaktuatorischen Steuereinheit und dem Verbindungsstecker auszeichnet.

Diese Aufgabe wird erfindungsgemäß bei einem Injektor der angegebenen Art dadurch gelöst, dass die elektrische Verbindung ein Kontaktelement umfasst, das in einen Isolierkörper integrierte Leiterbahnen aufweist, die mit den Anschlüssen der Steuereinheit und des Verbindungssteckers verbunden sind, dass das eine Ende des Isolierkörpers an der Steuereinheit oder dem Verbindungsstecker anliegt und das andere Ende mit Abstand vom Verbindungsstecker oder der Steuereinheit angeordnet ist und dass das Kontaktelement eine elastische Einrichtung zum Verspannen des an der Steuereinheit oder dem Verbindungsstecker anliegenden Isolierkörpers mit der Steuereinheit oder dem Verbindungsstecker aufweist.

Die erfindungsgemäße Lösung sieht die Anordnung eines Kontaktelementes zwischen der piezoaktuatorischen Steuereinheit und dem Verbindungsstecker vor, das in besonders einfacher und robuster Weise die Steuereinheit (den Piezoaktor) mit dem Verbindungsstecker elektrisch verbindet. Im Kontaktelement sind die Leiterbahnen im Injektorkörper elektrisch isoliert, wobei das Kontaktelement für ausreichende mechanische Stabilität sorgt. Die vorgesehene elastische Einrichtung zum Verspannen sorgt für eine Zugentlastung an der Verbindungsstelle zwischen dem Kontaktelement und der Steuereinheit oder dem Verbindungsstecker.

Das Kontaktelement besitzt Leiterbahnen, im Wesentlichen zwei Leiterbahnen (Plus- und Minuspol der elektrischen Verbindung), die zur Ausbildung des Isolierkörpers vorzugsweise mit einem Kunststoff umspritzt sind. Die vorgesehene elastische Einrichtung zum Verspannen des Isolierkörpers mit der Steuereinheit oder dem Verbindungsstecker schützt die entsprechenden Leiterverbindungsstellen vor Vibrationen und gewährleistet somit eine dauerhafte Haltbarkeit derselben. Mit Hilfe der elastischen Einrichtung wird das an der Steuereinheit oder dem Verbindungsstecker, vorzugsweise an der Steuereinheit, anliegende Kontaktelement mit einer geeigneten Axialkraft mit der Steuereinheit oder dem Verbindungsstecker, vorzugsweise der Steuereinheit, verspannt.

Der Isolierkörper dient der elektrischen Isolierung der Leiterbahnen im insbesondere metallischen Injektorkörper und gewährleistet gleichzeitig eine hohe mechanische Stabilität und eine gute Montagefähigkeit.

Während das eine Ende des Isolierkörpers des Kontaktelementes am entsprechenden Gegenelement, nämlich der Steuereinheit oder dem Verbindungsstecker, anliegt, ist das andere Ende des Isolierkörpers mit Abstand vom entsprechenden Gegenelement, nämlich dem Verbindungsstecker oder der Steuereinheit angeordnet. Vorzugsweise liegt das eine Ende des Isolierkörpers an der Steuereinheit an, während das andere Ende im Abstand vom Verbindungsstecker angeordnet ist. Durch diese Anordnung bzw. Ausbildung werden thermische Längenänderungen des Kontaktelementes und axiale Relativbewegungen bzw. Schwingungen desselben, die insbesondere durch die Betätigung der piezoaktuatorischen Steuereinheit hervorgerufen werden, kompensiert, wodurch eine Belastungsreduktion der Verbindungsstellen der elektrischen Leiter erreicht wird.

Eine Doppel-S-Geometrie wird hier als Ausgleichselement bevorzugt.

Bei einer Längenvergrößerung oder einer Axialbewegung des Kontaktelementes kann sich dieses, wenn es an der Steuereinheit anliegt, in Folge des zwischen Kontaktelement und Verbindungsstecker vorgesehenen Freiraumes in Richtung auf den Verbindungsstecker bewegen, ohne dass hierdurch entsprechende Spannungen oder Belastungen verursacht werden. Die elektrischen Leiter und ihre Verbindungsstellen zwischen Kontaktelement und den beiden Gegenelementen werden hierdurch nicht wesentlich zusätzlich belastet.

Entsprechende Längenausdehnungen bzw. Bewegungen des Kontaktelementes werden durch die elastische Verbindung zwischen Kontaktelement und dem zugehörigen Gegenelement im Wesentlichen nicht behindert. Die elastische Einrichtung verspannt das Kontaktelement mit dem Gegenelement, insbesondere der Steuereinheit, und sorgt somit für eine stabile Verbindung, ermöglicht jedoch andererseits die vorstehend geschilderten Bewegungen bzw. Relativbewegungen.

Vorzugsweise umfasst das Kontaktelement eine weitere elastische Einrichtung zum Verbinden des mit Abstand vom Verbindungsstecker oder der Steuereinheit angeordneten Isolierkörpers. Bei dieser Ausführungsform wird daher auch dort eine elastische Verbindungseinrichtung vorgesehen, wo das Ende des Kontaktelementes mit Abstand vom Gegenelement angeordnet ist, um eine entsprechende Bewegungsfreiheit zu ermöglichen. Es handelt sich hierbei vorzugsweise um das am Verbindungsstecker angeordnete Ende des Kontaktelementes. Diese weitere elastische Einrichtung sorgt für eine Stabilisierung der entsprechenden Verbindung zwischen dem Kontaktelement und dem Gegenelement und wirkt auch als Zugentlastung, die die unterschiedlichen thermischen Ausdehnungskoeffizienten und den hochdynamischen Piezohub (axiale Relativbewegung zur Steuereinheit) ausgleichen kann. Die elastische Einrichtung zum Verspannen des anliegenden Isolierkörpers weist ein am Isolierkörper und der Steuereinheit oder dem Verbindungsstecker, vorzugsweise dem Isolierkörper und der Steuereinheit, fixiertes Federelement auf. Die Fixierung an der Steuereinheit erfolgt dabei so, dass das Federelement durch Eingriff desselben in einer Ausnehmung oder hinter einer Hinterschneidung der Steuereinheit verrastet ist. Hierdurch lässt sich das Kontaktelement rasch und einfach an der Steuereinheit befestigen bzw. mit dieser verspannen, so dass sich diese Elemente ohne Weiteres zusammen in das Injektorgehäuse einsetzen lassen. Bei der weiteren elastischen Einrichtung, die am anderen Ende des Kontaktelementes zum Einsatz kommt, handelt es sich vorzugsweise um eine am Isolierkörper und am Verbindungsstecker fixierte Lasche, insbesondere Omega-Lasche.

Der Isolierkörper sorgt nicht nur für eine Isolierung der Leiterbahnen zwischen Steuereinheit und Verbindungsstecker, sondern gewährleistet gleichzeitig eine hohe mechanische Stabilität und eine gute Montagefähigkeit der Kontaktierung. Bewegungen des Kontaktelementes in radialer Richtung werden hierdurch verhindert.

Die Leiterbahnen des Kontaktelementes, die in den zugehörigen Isolierkörper integriert sind, treten vorzugsweise stirnseitig aus dem Isolierkörper aus und sind mit den zugehörigen Anschlüssen des Verbindungssteckers sowie der Steuereinheit verbunden, insbesondere verschweißt. Die Anschlüsse des Verbindungssteckers bzw. der Steuereinheit sind insbesondere als Pins ausgebildet, an deren Spitzen die entsprechenden Verbindungsstellen vorgesehen sind. Um Platz für diese Verbindungsstellen zu schaffen, weist der Isolierkörper des Kontaktelementes vorzugsweise stirnseitig eine Ausnehmung zur Aufnahme der Anschlüsse der Steuereinheit oder des Verbindungssteckers und der entsprechenden Verbindungsstellen mit den Leiterbahnen des Kontaktelementes auf. Hierdurch wird der planare Kontakt zwischen der Stirnseite des Isolierkörpers und dem Gegenelement, insbesondere der Steuereinheit, nicht verhindert. Vorzugsweise ist der Isolierkörper an beiden Stirnseiten mit einer derartigen Ausnehmung versehen, um die Verbindungsstellen sowohl mit der Steuereinheit als auch mit dem Verbindungsstecker aufnehmen zu können.

In Weiterbildung der Erfindung ist die radiale Position des Kontaktelementes auf der Steuereinheit festgelegt. Hierdurch wird die richtige Polarität der Leiterbahnen bei der Montage gewährleistet, beispielsweise durch geeignete Kodierung der radialen Position des Kontaktelementes auf dem Steuerelement bzw. dem Piezoaktor.

Erfindungsgemäß wird somit ein Kontaktelement mit integrierter Zugentlastung zur Verbindung eines Piezoaktors mit einem Verbindungsstecker in einem Injektor vorgesehen. Das Kontaktelement sorgt für einen Schutz der Verbindungsstellen zwischen Piezoaktor und Verbindungsstecker (Einspritzsystem) gegen äußere und innere Vibrationen. Zur Herstellung des Kontaktelementes können Standard-Maschinenbauelemente verwendet werden. Es lässt sich somit ein gut auslegbares Design sowie eine gute Einstellung der erforderlichen Axialkraft erreichen. Die elektrische Isolation der Leiterbahnen wird durch den Isolierkörper des Kontaktelementes erreicht, wobei zur Ausbildung des Isolierkörpers eine kostengünstige Kunststoffumspritzung durchgeführt werden kann. Dadurch lassen sich potenzielle Feldausfälle durch Kurz- oder Masseschluss vermeiden. Des Weiteren sorgt der Isolierkörper für eine Führung des Kontaktelementes im Injektorkörper.

Eine hohe Flexibilität bezüglich der erforderlichen Länge ist durch die Verwendung von Wechseleinsätzen im Spritzguss- und Stanzwerkzeug möglich.

Die vorliegende Erfindung bezieht sich ferner auf ein Kontaktelement zur Herstellung einer elektrischen Verbindung zwischen einer piezoaktuatorischen Steuereinheit und einem Verbindungsstecker in einem Injektor eines Einspritzsystems einer Brennkraftmaschine, das die vorstehend beschriebenen Merkmale aufweist. Dieses Kontaktelement mit Isolierkörper und elastischer Einrichtung zum Verspannen sorgt für eine besonders sichere und robuste Kontaktierung zwischen der piezoaktuatorischen Steuereinheit (dem Piezoaktor) und dem am Injektorgehäusekopf vorgesehen Verbindungsstecker, der mit der Stromversorgung des Systems verbindbar ist.

Die Erfindung wird nachfolgend anhand eines Ausführungsbeispiels in Verbindung mit der Zeichnung im Einzelnen erläutert. Es zeigen:
- Figur 1: einen schematischen Längsschnitt durch einen Teil eines Injektorkörpers; und
- Figur 2: eine vergrößerte Darstellung des unteren Teiles der Figur 1.

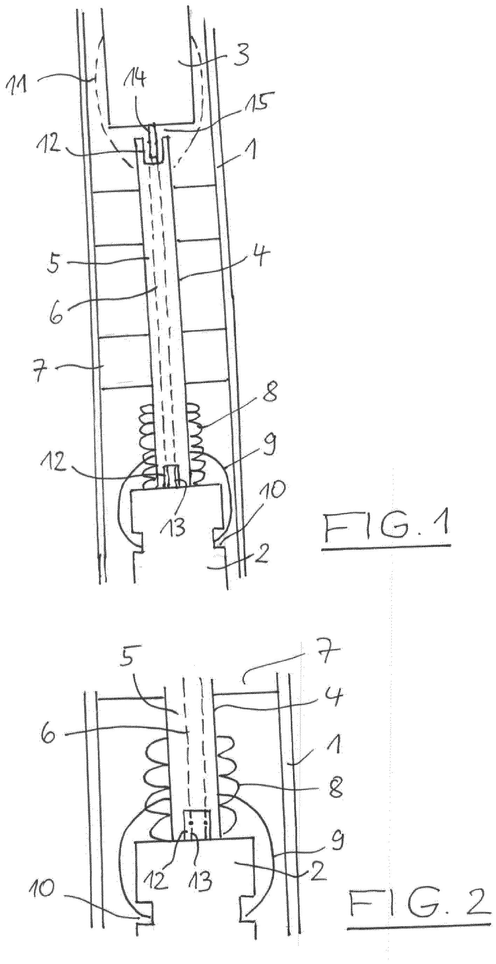

Figur 1 zeigt einen Teil eines Injektorkörpers 1 mit einer piezoaktuatorischen Steuereinheit 2 und einem am Kopf des Injektorkörpers 1 angeordneten Verbindungsstecker 3. Um die piezoaktuatorische Steuereinheit 2 betätigen zu können, weist diese eine elektrische Verbindung mit dem Verbindungsstecker 3 auf, welcher wiederum eine elektrische Verbindung zu einer Steuereinheit des zugehörigen Einspritzsystems einer Brennkraftmaschine besitzt. Durch Ansteuerung der piezoaktuatorischen Steuereinheit 2 über elektrische Impulse erfährt die Steuereinheit 2 periodisch Längenausdehnungen und Kontraktionen, die das Einspritzen von Kraftstoff über einen nicht gezeigten Düsenmechanismus bewirken.

Die elektrische Verbindung zwischen der piezoaktuatorischen Steuereinheit und dem Verbindungsstecker 3 ist über ein Kontaktelement 4 realisiert, das in einen Isolierkörper 5 integrierte Leiterbahnen 6 aufweist. Im hier dargestellten Ausführungsbeispiel sind 2 Leiterbahnen 6 im Isolierkörper 5 vorgesehen, welche stirnseitig vom Isolierkörper 5 vorstehen, wie dargestellt. Die vorstehenden Leiter sind in stirnseitigen Ausnehmungen 12 des Isolierkörpers 5 angeordnet und dort mit Anschlüssen 13, 14 der Steuereinheit 2 und des Verbindungssteckers 3 verschweißt.

Das Kontaktelement 4 mit dem entsprechenden Isolierkörper 5 bildet eine geeignete Isolierung und Führung für die Leiterbahnen 6, so dass diese gegenüber dem metallischen Gehäuse des Injektorkörpers 1 isoliert und ferner stabilisiert und geschützt werden. Schematisch dargestellte Führungselemente 7 am Isolierkörper 5 sorgen für die entsprechende Führung des Kontaktelementes 4 im Injektorkörper 1.

Die piezoaktuatorische Steuereinheit 2 führt somit relativ zum Injektorkörper 1 entsprechende aktuatorische Bewegungen durch, während der Verbindungsstecker 3 am Kopf des Injektorgehäuses 1 fixiert ist. Um die entsprechenden Relativbewegungen zwischen Steuereinheit 2 und Verbindungsstecker 3 zu ermöglichen, ist das Kontaktelement 4 kürzer ausgebildet als der Abstand zwischen Steuereinheit 2 und Verbindungsstecker 3, so dass zwischen Kontaktelement 4 und Verbindungsstecker 3 ein Freiraum 15 verbleibt, der die entsprechenden Längenausdehnungen aufnehmen kann. Dieser Freiraum kann ferner temperaturbedingte Längenänderungen des Systems aufnehmen. Am gegenüberliegenden Ende liegt das Kontaktelement 5 am Kopf der Steuereinheit 2 an.

Um sichere Übergänge zwischen den beiden Enden des Kontaktelementes 4 und der Steuereinheit 2 sowie dem Verbindungsstecker 3 zu ermöglichen, sind jeweils elastische Einrichtungen 8 und 11 vorgesehen. Mit der elastischen Einrichtung 8, bei der es sich um ein Federelement handelt, ist das Kontaktelement 5 mit der Steuereinheit 2 verspannt. Hierzu ist das Federelement 8 am Isolierkörper fixiert und greift mit einer Klammer 9 hinter eine an der Steuereinheit 2 vorgesehene Hinterschneidung 10. Hierdurch wird das Kontaktelement 4 an der Steuereinheit 2 fixiert, wobei Steuereinheit und Kontaktelement zusammen entsprechende Bewegungen ausführen können, ohne dass die elektrischen Verbindungen hierdurch beeinträchtigt werden. Zwischen den Teilen 4 und 2 ist keine Relativbewegung zulässig. Die Vorspannkraft durch 8 muss so groß sein, dass Relativbewegungen verhindert werden.

Eine derartige elastische Einrichtung 11 ist auch an der Verbindungsstelle zwischen Kontaktelement 4 und Verbindungsstecker 3 vorgesehen, wobei diese elastische Einrichtung 11, die beispielsweise die Form einer Omega-Lasche besitzen kann, die Verbindung zwischen Kontaktelement und Verbindungsstecker stabilisiert, ohne die Beweglichkeit des Kontaktelementes 4 relativ zum Verbindungsstecker 3 einzuschränken.

Figur 2 zeigt die Verbindung zwischen Kontaktelement 4 und der Steuereinheit 2 in schematischer Weise im vergrößerten Maßstab. Man erkennt, dass die stirnseitig im Isolierkörper 5 des Kontaktelementes 4 angeordnete Ausnehmung 12 die elektrischen Anschlüsse 13 der Steuereinheit 2 mit den Verbindungsstellen der Leiterbahnen 6 des Kontaktelementes 4 aufnimmt. Die elastische Einrichtung 8 in Form eines Federelementes mit Klammer 9 sichert die Fixierung zwischen Kontaktelement 4 und Steuereinheit 2, ermöglicht aber die entsprechenden Bewegungen, wie vorstehend ausgeführt, jedoch keine Relativbewegungen.

Das Federelement 8 ist zur Gewährleistung der entsprechenden Vorspannkraft statisch vorgespannt.

Die Omega-Lasche muss nicht zwingend zwischen 3 und 5 liegen. Ein zweiteiliger Isolierkörper 5 mit dazwischen angeordneter Ausgleichslasche ist auch möglich.

## Patentansprüche

1. Injektor eines Einspritzsystems einer Brennkraftmaschine mit einem Injektorgehäuse, einer piezoaktuatorischen Steuereinheit, einem Verbindungsstecker am Kopf des Injektorgehäuses und einer elektrischen Verbindung zwischen der Steuereinheit und dem Verbindungsstecker innerhalb des Injektorgehäuses, wobei die elektrische Verbindung ein Kontaktelement (4) umfasst, das in einen Isolierkörper (5) integrierte Leiterbahnen (6) aufweist, die mit den Anschlüssen (13, 14) der Steuereinheit (2) und des Verbindungssteckers (3) verbunden sind, dass das eine Ende des Isolierkörpers (5) an der Steuereinheit (2) oder dem Verbindungsstecker (3) anliegt und das andere Ende mit Abstand vom Verbindungsstecker (3) oder der Steuereinheit (2) angeordnet ist und dass das Kontaktelement (4) eine elastische Einrichtung (8) zum Verspannen des an der Steuereinheit (2) oder dem Verbindungsstecker anliegenden Isolierkörpers (5) mit der Steuereinheit (2) oder dem Verbindungsstecker aufweist, wobei die elastische Einrichtung (8) zum Verspannen des anliegenden Isolierkörpers (5) ein am Isolierkörper (5) und der Steuereinheit (2) oder dem Verbindungsstecker fixiertes Federelement aufweist, wobei das Federelement durch Eingriff desselben in eine Ausnehmung oder hinter eine Hinterschneidung (10) der Steuereinheit (2) oder des Verbindungssteckers verrastet ist.

2. Injektor nach Anspruch 1, **dadurch gekennzeichnet, dass** das Kontaktelement (4) eine weitere elastische Einrichtung (11) zum Verbinden des mit Abstand vom Verbindungsstecker (3) oder der Steuereinheit angeordneten Isolierkörpers (5) umfasst.

3. Injektor nach Anspruch 2, **dadurch gekennzeichnet, dass** die weitere elastische Einrichtung (11) eine am Isolierkörper (5) und am Verbindungsstecker (3) fixierte Lasche, insbesondere Omega-Lasche, ist.

4. Injektor nach einem der vorangehenden Ansprüche, **dadurch gekennzeichnet, dass** der Isolierkörper (5) des Kontaktelementes (4) an der Gehäuseinnenwand oder an Führungselementen (7) anliegt und durch diese geführt wird.

5. Injektor nach einem der vorangehenden Ansprüche, **dadurch gekennzeichnet, dass** der Isolierkörper (5) stirnseitig eine Ausnehmung (12) zur Aufnahme der Anschlüsse (13, 14) der Steuereinheit (2) oder des Verbindungssteckers (3) und der entsprechenden Verbindungsstellen mit den Leiterbahnen (6) des Kontaktelementes (4) aufweist.

6. Injektor nach einem der vorangehenden Ansprüche, **dadurch gekennzeichnet, dass** die radiale Position des Kontaktelementes (4) auf der Steuereinheit (2) festgelegt ist.

## Claims

1. Injector of an injection system of an internal combustion engine, having an injector housing, having a piezo-actuator control unit, having a connecting plug on the head of the injector housing, and having an electrical connection between the control unit and the connecting plug within the injector housing, wherein the electrical connection comprises a contact element (4) which has conductor tracks (6) integrated into an insulating body (5), which conductor tracks are connected to the terminals (13, 14) of the control unit (2) and of the connecting plug (3), wherein one end of the insulating body (5) abuts against the control unit (2) or against the connecting plug (3) and the other end is arranged with a spacing to the connecting plug (3) or to the control unit (2), and wherein the contact element (4) has an elastic device (8) by means of which the insulating body (5), which abuts against the control unit (2) or against the connecting plug, is braced against the control unit (2) or the connecting plug, wherein the elastic device (8) for bracing the abutting insulating body (5) has a spring element which is fixed to the insulating body (5) and to the control unit (2) or the connecting plug, wherein the spring element is locked by engagement thereof into a recess or behind an undercut (10) of the control unit (2) or of the connecting plug.

2. Injector according to Claim 1, **characterized in that** the contact element (4) comprises a further elastic device (11) for the connection of the insulating body (5) that is arranged with a spacing to the connecting plug (3) or to the control unit.

3. Injector according to Claim 2, **characterized in that** the further elastic device (11) is a lug, in particular omega-shaped lug, which is fixed to the insulating body (5) and to the connecting plug (3).

4. Injector according to any of the preceding claims, **characterized in that** the insulating body (5) of the contact element (4) bears against the housing internal wall or against guide elements (7), and is guided thereby.

5. Injector according to any of the preceding claims, **characterized in that** the insulating body (5) has, on the face side, a recess (12) for receiving the terminals (13, 14) of the control unit (2) or of the connecting plug (3) and for receiving the corresponding connecting points to the conductor tracks (6) of the contact element (4).

6. Injector according to any of the preceding claims, **characterized in that** the radial position of the contact element (4) on the control unit (2) is fixed.

## Revendications

1. Injecteur d'un système d'injection d'un moteur à combustion interne, comprenant un boîtier d'injecteur, une unité de commande à actionnement piézoélectrique, une fiche de connexion à la partie supérieure du boîtier d'injecteur et une connexion électrique entre l'unité de commande et la fiche de connexion à l'intérieur du boîtier d'injecteur,
la connexion électrique comprenant un élément de contact (4) qui présente des pistes conductives (6) intégrées dans un corps isolant (5) et qui sont reliées aux bornes (13, 14) de l'unité de commande (2) et de la fiche de connexion (3), ladite une extrémité du corps isolant (5) étant adjacente à l'unité de commande (2) ou à la fiche de connexion (3), et l'autre extrémité étant disposée à distance de la fiche de connexion (3) ou de l'unité de commande (2), et l'élément de contact (4) présentant un dispositif élastique (8) permettant de serrer le corps isolant (5) adjacent à l'unité de commande (2) ou à la fiche de connexion avec l'unité de commande (2) ou la fiche de connexion, le dispositif élastique (8) présentant pour le serrage du corps isolant adjacent (5) un élément faisant ressort fixé au corps isolant (5) et à l'unité de commande (2) ou à la fiche de connexion, l'élément faisant ressort étant enclenché par la mise en prise de celui-ci dans un évidement ou derrière une contre-dépouille (10) de l'unité de commande (2) ou de la fiche de connexion.

2. Injecteur selon la revendication 1, **caractérisé en ce que** l'élément de contact (4) comprend un autre dispositif élastique (11) pour relier le corps isolant (5) disposé à distance de la fiche de connexion (3) ou de l'unité de commande.

3. Injecteur selon la revendication 2, **caractérisé en ce que** l'autre dispositif élastique (11) est une languette fixée au corps isolant (5) et à la fiche de connexion (3), en particulier une languette oméga.

4. Injecteur selon l'une quelconque des revendications précédentes, **caractérisé en ce que** le corps isolant (5) de l'élément de contact (4) est adjacent à la paroi intérieure de boîtier ou à des éléments de guidage (7) et est guidé par ceux-ci.

5. Injecteur selon l'une quelconque des revendications précédentes, **caractérisé en ce que** le corps isolant (5) présente sur la face frontale un évidement (12) pour recevoir les bornes (13, 14) de l'unité de commande (2) ou de la fiche de connexion (3) et des points de connexion correspondants avec les pistes conductives (6) de l'élément de contact (4).

6. Injecteur selon l'une quelconque des revendications précédentes, **caractérisé en ce que** la position radiale de l'élément de contact (4) sur l'unité de commande (2) est fixe.
